# EUROPEAN PATENT SPECIFICATION

(11) **EP 4 141 937 B1**
(45) Date of publication and mention of the grant of the patent: **09.07.2025**
(21) Application number: 22190870.0
(22) Date of filing: 17.08.2022
(51) Int. Cl.: H01L 27/12, G06F 1/16, H10K 59/121, H10K 59/124, H10K 59/131

(54) **DISPLAY DEVICE**
ANZEIGEVORRICHTUNG
DISPOSITIF D'AFFICHAGE

(30) Priority: 17.08.2021 KR 20210108202
(43) Date of publication of application: 01.03.2023
(73) Proprietor: Samsung Display Co., Ltd., Yongin-si, Gyeonggi-do 17113 (KR)
(72) Inventor: KIM, Daesoo, Seoul (KR); CHOI, Daewon, Cheonan-si (KR); YEO, Yunjong, Hwaseong-si (KR)
(74) Representative: Marks & Clerk LLP

(56) References cited:
- CN-A- 111 508 377
- CN-A- 112 687 193
- US-A1- 2017 205 543
- US-A1- 2020 243 801
- US-A1- 2020 251 539
- US-A1- 2021 249 624

## Description

### BACKGROUND

### 1. FIELD

Embodiments relate generally to a display device. More particularly, embodiments relate to a display device that provides visual information.

### 2. DESCRIPTION OF THE RELATED ART

A flat panel display device is used as a display device replacing a cathode ray in a display device, due to characteristics such as light weight and thinness. Representative examples of such flat panel display devices are a liquid crystal display device ("LCD") and an organic light emitting display device ("OLED").

The display device may include a module-corresponding area in which a functional module is disposed, and a display area surrounding the module-corresponding area and in which emission structures are disposed. Here, the functional module may be disposed on a lower surface of a substrate included in the display device. A display device capable of displaying an image by arranging emission structures in the module-corresponding area has been developed.

CN 112 687 193 A relates to a display panel having a phase compensation layer.

### SUMMARY

The invention is defined in claim 1. Preferred embodiments are defined in the dependent claims.

Embodiments provide a display device with improved display quality.

An embodiment of a display device includes a substrate including a (functional) module-corresponding area, a display area adjacent to the module-corresponding area, and a pixel circuit area at a side of the display area, an inorganic insulating layer in the display area on the substrate, a (light) phase compensation layer in the module-corresponding area, on the substrate, and including a same material as the inorganic insulating layer, a signal line in the module-corresponding area, on the phase compensation layer and extending from the module-corresponding area to the pixel circuit area, and an organic insulating layer on the inorganic insulating layer and extending from the display area to the module-corresponding area to cover the signal line and the phase compensation layer.

In an embodiment, the display device may further include an etch stop layer in the module-corresponding area, between the substrate and the phase compensation layer, and including a transparent material.

In an embodiment, an etch rate of the etch stop layer may be smaller than an etch rate of the phase compensation layer.

In an embodiment, the etch stop layer may include indium gallium zinc oxide ("IGZO") or amorphous silicon.

In an embodiment, the etch stop layer may be in an entirety of the module-corresponding area.

In an embodiment, the etch stop layer may be a pattern which overlaps each of the phase compensation layer and the signal line.

In an embodiment, the signal line may include a conductive metal oxide or a transparent conductive material.

In an embodiment, the transparent conductive material may include indium tin oxide ("ITO"), indium zinc oxide ("IZO") or indium gallium oxide ("IGO").

In an embodiment, the inorganic insulating layer may include silicon oxide or silicon nitride.

In an embodiment, a refractive index of the organic insulating layer may be greater than a refractive index of the phase compensation layer and smaller than a refractive index of the signal line.

In an embodiment, a refractive index of the signal line may be about 1.9 or more in a visible light region.

In an embodiment, the display device may further include a functional module in the module-corresponding area, on a lower surface of the substrate.

In an embodiment, the functional module may include a camera module, a face recognition sensor module, a pupil recognition sensor module, an acceleration sensor module, a proximity sensor module, an infrared sensor module or an illuminance sensor module.

In an embodiment, the display device may further include a pixel circuit structure in the pixel circuit area, on the substrate, and including a semiconductor element, and an emission structure in the module-corresponding area, on the substrate.

In an embodiment, the signal line may electrically connect the pixel circuit structure and the emission structure.

An embodiment of a display device includes a substrate including a module-corresponding area, a display area adjacent to the module-corresponding area, and a pixel circuit area at a side of the display area, a first inorganic insulating layer in the display area and the module-corresponding area, on the substrate, a second inorganic insulating layer in the display area, on the first inorganic insulating layer, a (light) phase compensation layer in the module-corresponding area, on the substrate, and including a same material as the second inorganic insulating layer, a signal line in the module-corresponding area, on the phase compensation layer, and extending from the module-corresponding area to the pixel circuit area, and an organic insulating layer on the second inorganic insulating layer and extending from the display area to the module-corresponding area to cover the signal line and the phase compensation layer.

In an embodiment, the display device may further include an etch stop layer in the module-corresponding area, on the first inorganic insulating layer, and including a transparent material.

In an embodiment, an etch rate of the etch stop layer may be smaller than an etch rate of the phase compensation layer.

In an embodiment, the etch stop layer may include indium gallium zinc oxide or amorphous silicon.

In an embodiment, each of the first inorganic insulating layer and the second inorganic insulating layer may include silicon oxide or silicon nitride.

In one or more embodiments of a display device, as a light phase compensation layer including an inorganic insulating material is in a functional module area, an occurrence of a flare phenomenon may be reduced.

In addition, as a etch stop layer including a transparent material is in the functional module area between the substrate and the phase compensation layer, a non-uniformity of a thickness of the phase compensation layer in a large-area display device may be improved.

### BRIEF DESCRIPTION OF THE DRAWINGS

Illustrative, non-limiting embodiments will be more clearly understood from the following detailed description in conjunction with the accompanying drawings.
FIG. 1 and 2 are perspective views illustrating an embodiment of a display device.
FIG. 3 is a plan view illustrating the display device of FIG. 1.
FIG. 4 and 5 are partially enlarged plan views illustrating an embodiment of area 'A' of FIG. 3.
FIG. 6 is a cross-sectional view taken along lines I-I' and II-II' of FIG. 5.
FIG. 7, 8, 9, 10, 11, 12, 13, 14, 15, and 16 are cross-sectional views illustrating embodiments of structures provided by a method of manufacturing the display device of FIG. 6.
FIG. 17 is a cross-sectional view illustrating an embodiment of a display device.
FIG. 18 is a cross-sectional view illustrating an embodiment of a display device.
FIG. 19 is a cross-sectional view illustrating an embodiment of a display device.

### DETAILED DESCRIPTION

Hereinafter, embodiments of the present disclosure will be explained in detail with reference to the accompanying drawings. The same reference numerals are used for the same components in the drawings, and redundant descriptions of the same components will be omitted.

It will be understood that when an element is referred to as being related to another element such as being "on" another element, it can be directly on the other element or intervening elements may be present therebetween. In contrast, when an element is referred to as being related to an element such as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value. Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments are described herein with reference to cross section illustrations that are schematic illustrations of embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

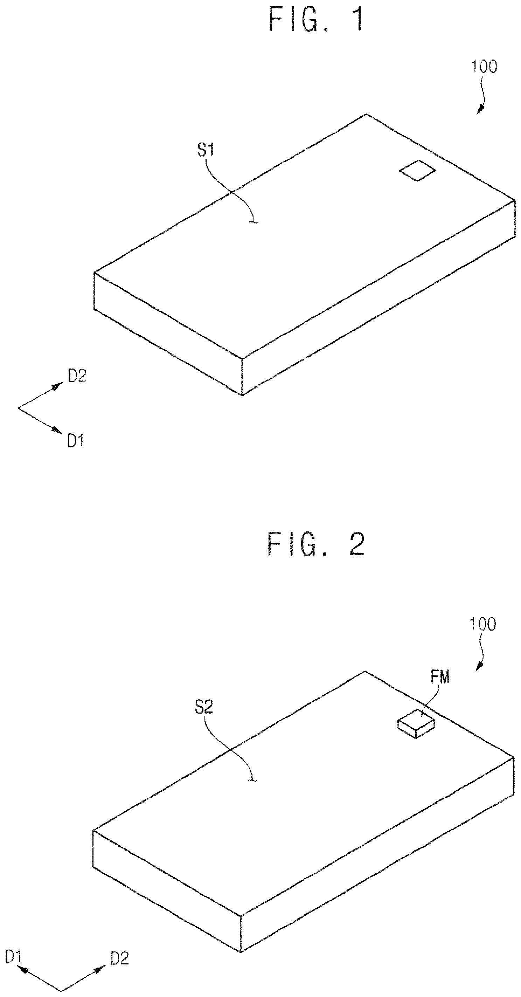

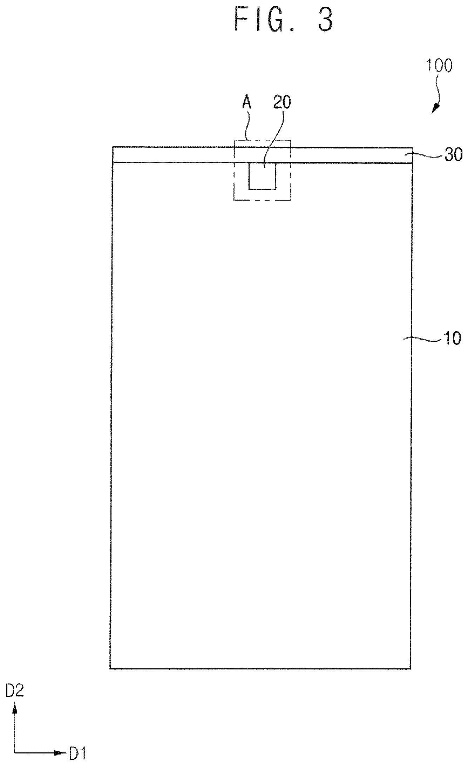

FIG. 1 and 2 are perspective views illustrating an embodiment of a display device 100. FIG. 3 is a plan view illustrating the display device 100 of FIG. 1.

Referring to FIGS. 1, 2, and 3, the display device 100 may include a display area 10, a module-corresponding area 20 (e.g., functional module area), and a pixel circuit area 30.

The display area 10 is adjacent to the module-corresponding area 20 and may surround at least a portion of the module-corresponding area 20. The pixel circuit area 30 may be positioned at one side of the display area 10. In addition, the pixel circuit area 30 may be adjacent to one side of the module-corresponding area 20. That is, first to third sides of the module-corresponding area 20 may be adjacent to the display area 10, and a fourth side of the module-corresponding area 20 may be adjacent to the pixel circuit area 30, so as to be surrounded by the display area 10 together with the pixel circuit area 30.

The display device 100 may be divided into (or include) a first surface S1 and a second surface S2. The first surface S1 may correspond to a surface on which an image is displayed (e.g., display surface). The second surface S2 may correspond to a surface on which an image is not displayed. The module-corresponding area 20 may be in and form a part of the display area 10. An image may be displayed and/or light may be emitted at the module-corresponding area 20, without being limited thereto.

The display device 100 may include a functional module FM. The functional module FM may be disposed to overlap (or correspond to) the module-corresponding area 20, on the second surface S2. In an embodiment, an image may be displayed at both a portion of the first surface S1 overlapping the module-corresponding area 20 and a portion of the first surface S1 overlapping the display area 10. In an embodiment, for example, the functional module FM may provide a function to the display device 100 and may include a camera module, a face recognition sensor module, a pupil recognition sensor module, an acceleration sensor module, a proximity sensor module, an infrared sensor module, an illuminance sensor module, and the like. In an embodiment, the functional module FM may include the camera module. In this case, the functional module FM may capture an image by capturing external light incident to the display device 100 through a portion of the first surface S1 overlapping the module-corresponding area 20, to provide an image-capturing function to the display device 100.

However, although a shape of the functional module FM is shown as having a rectangular planar shape, the planar shape of the functional module FM is not limited thereto. In an embodiment, for example, the functional module FM may have a triangular planar shape, a rhombus planar shape, a polygonal planar shape, a track-type planar shape, a circular planar shape, or an elliptical planar shape. In addition, when a planar shape of the functional module FM is changed, a planar shape of the module-corresponding area 20 may also be changed according to an outer shape of the functional module FM.

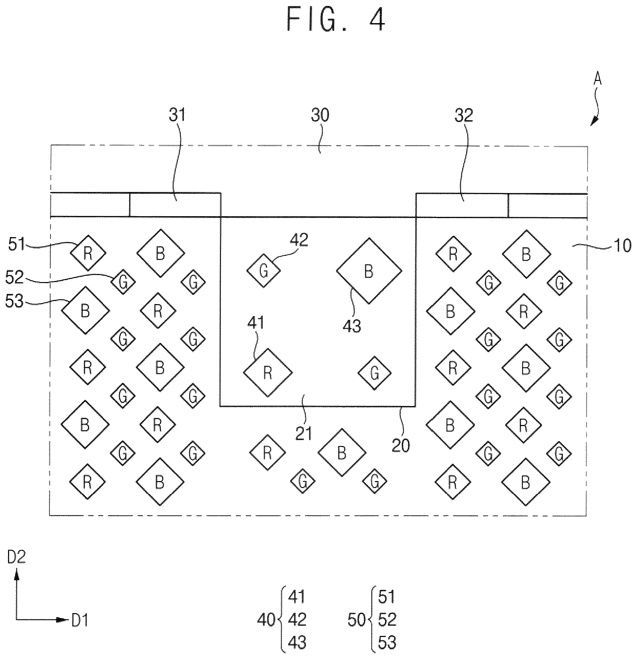

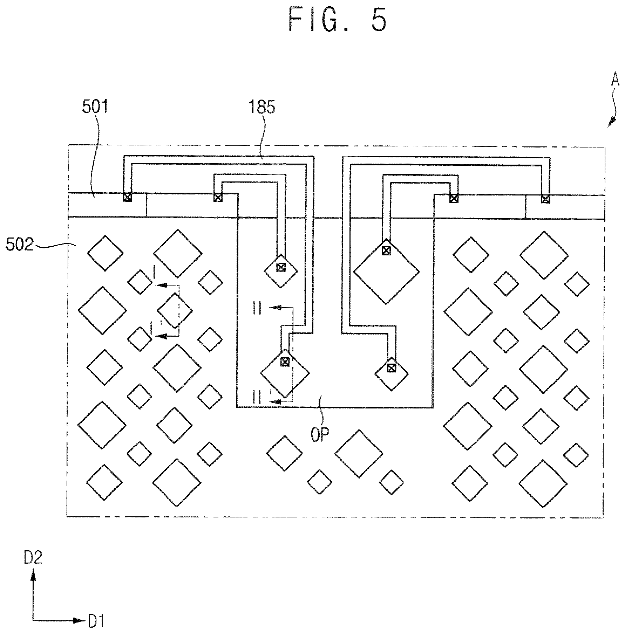

FIG. 4 and 5 are partially enlarged plan views illustrating embodiments of area 'A' of FIG. 3.

Referring to FIG. 4, the display area 10 may include (or correspond to) a second pixel area 50, and the module-corresponding area 20 may include a transparent area 21 and a first pixel area 40. In addition, the pixel circuit area 30 may include a first pixel circuit area 31 provided in plural including a plurality first pixel circuit areas 31 and a second pixel circuit area 32 provided in plural including a plurality of second pixel circuit areas 32.

The second pixel area 50 may include a plurality of second sub-pixel areas 51, 52, and 53 emitting light of different colors. The first pixel area 40 may include a plurality of first sub-pixel areas 41, 42, and 43 emitting light of different colors. The lights of different colors may be used to display an image within the display area 10, without being limited thereto. The pixel area (or sub-pixel area) may otherwise be referred to as a light emission area.

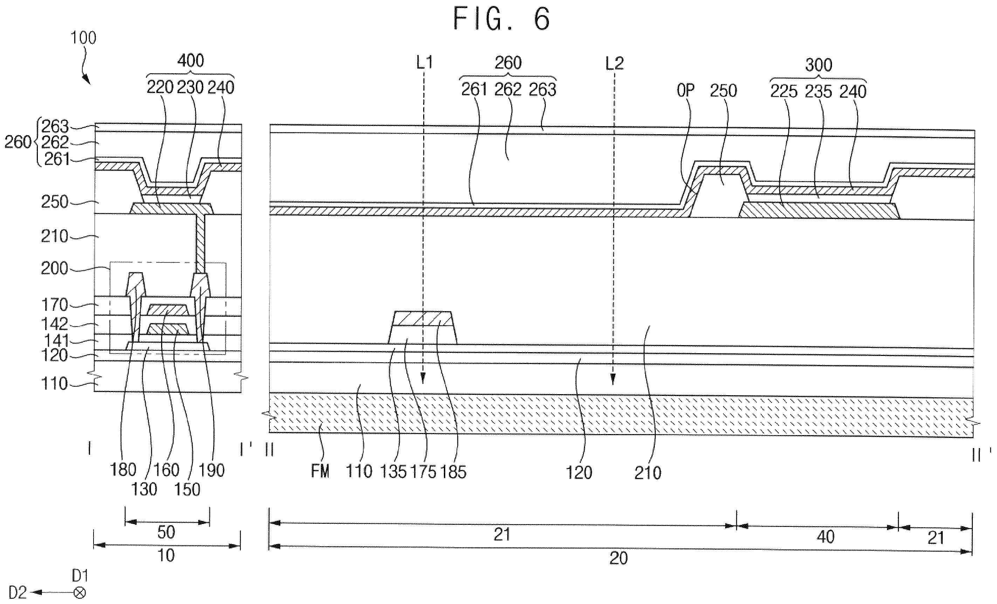

In an embodiment, for example, the second sub-pixel areas 51, 52, and 53 may include a second red pixel area 51 in which a red emission structure R (e.g., a second emission structure 400 of FIG. 6) emitting red light is disposed, a second green pixel area 52 in which a green emission structure G emitting green light is disposed, and a second blue pixel area 53 in which a blue emission structure B emitting blue light is disposed. In addition, the first sub-pixel areas 41, 42, and 43 may include a first red pixel area 41 in which a red emission structure R (e.g., a first emission structure 300 of FIG. 6) emitting red light is disposed, a first green pixel area 42 in which a green emission structure G emitting green light is disposed, and a first blue pixel area 43 in which a blue emission structure B emitting blue light is disposed.

The plurality of second sub-pixel areas 51, 52, and 53 may be repeatedly arranged in the display area 10. The plurality of first sub-pixel areas 41, 42, and 43 may be repeatedly arranged in the module-corresponding area 20. That is, the emission structures R, G, and B may be repeatedly arranged in the display area 10, and the emission structures R, G, and B may be repeatedly arranged in the module-corresponding area 20.

In the module-corresponding area 20, a portion other than the plurality of first sub-pixel areas 41, 42, and 43 (e.g., remaining portion of the module-corresponding area 20) may be defined as the transparent area 21. An opening OP may be positioned in the transparent area 21. In addition, the functional module FM may collect light incident from an outside through the opening OP.

The first pixel circuit areas 31 may be positioned adjacent to a first portion (e.g., the display area 10 positioned to a left of the module-corresponding area 20 in FIG. 4) of the display area 10 in the pixel circuit area 30, and may be arranged along a first direction D1. The second pixel circuit areas 32 may be positioned adjacent to a second portion (e.g., the display area 10 positioned to a right of the module-corresponding area 20 in FIG. 4) of the display area 10 in the pixel circuit area 30, and may be arranged along the first direction D1. The pixel circuit area 30 may be adjacent to both the display area 10 and the module-corresponding area 20 along a second direction D2 crossing the first direction D1. A thickness direction of the display device 100 and various components and layers thereof, may be defined along a third direction which crosses each of the first direction D1 and the second direction D2.

A pixel circuit structure (e.g., a first pixel circuit structure 501 of FIG. 5) electrically connected to an emission structure disposed in the module-corresponding area 20 may be disposed in the first and second pixel circuit areas 31 and 32. A pixel circuit structure (e.g., a second pixel circuit structure 502 of FIG. 5) electrically connected to an emission structure disposed in the display area 10 may be disposed in the display area 10. That is, a pixel circuit structure electrically connected to the emission structure disposed in the module-corresponding area 20 may not be disposed in the module-corresponding area 20 (e.g., may be excluded from the module-corresponding area 20).

Referring to FIG. 5, the second pixel circuit structure 502 may be disposed in the display area 10. The second pixel circuit structure 502 may include at least one semiconductor element 200 (see FIG. 6), at least one capacitor, and the like. The second pixel circuit structure 502 may drive the emission structure (e.g., the second emission structure 400 of FIG. 6). The second pixel circuit structure 502 may be disposed to overlap the emission structure and be under the emission structure along a thickness direction of the display device 100.

The first pixel circuit structure 501 may be disposed in the first and second pixel circuit areas 31 and 32. The first pixel circuit structure 501 may include at least one semiconductor element, at least one capacitor, and the like. The first pixel circuit structure 501 may drive the emission structure (e.g., the first emission structure 300 of FIG. 6). The first pixel circuit structure 501 and the emission structure may be electrically connected through a signal line 185.

FIG. 6 is a cross-sectional view taken along lines I-I' and II-II' of FIG. 5.

Referring to FIG. 6, the display device 100 may include a functional module FM, a substrate 110, a buffer layer 120, a semiconductor element 200, a first gate insulating layer 141, a second gate insulating layer 142, an interlayer insulating layer 170, a phase compensation layer 175, a signal line 185, an etch stop layer 135, a planarization layer 210, a pixel defining layer 250, a first emission structure 300, a second emission structure 400 and a thin film encapsulation structure 260.

Here, the semiconductor element 200 may include an active layer 130, a first gate electrode 150, a second gate electrode 160, a source electrode 180, and a drain electrode 190. The first emission structure 300 may include a first lower electrode 225, a first emission layer 235 and an upper electrode 240. The second emission structure 400 may include a second lower electrode 220, a second emission layer 230 and the upper electrode 240. In addition, the thin film encapsulation structure 260 may include a first inorganic thin film encapsulation layer 261, an organic thin film encapsulation layer 262, and a second inorganic thin film encapsulation layer 263.

As described in FIG. 1, as the display device 100 includes the display area 10, the module-corresponding area 20 and the pixel circuit area 30, the substrate 110 may also include the display area 10, the module-corresponding area 20 and the pixel circuit area 30 corresponding to those described above. That is, various components and layers of the display device 100 may also include the display area 10, the module-corresponding area 20 and the pixel circuit area 30 corresponding to those described above for the display device 100.

The substrate 110 may include a transparent material or an opaque material. In an embodiment, for example, the substrate 110 may include a quartz substrate, a synthetic quartz substrate, a calcium fluoride substrate, an F-doped quartz substrate, and a soda-lime glass. It may include a glass substrate, a non-alkali glass substrate, and the like. These may be used alone or in combination with each other. In an embodiment, the substrate 110 may be formed of (or include) a flexible transparent resin substrate. In an embodiment, for example, the substrate 110 may have a structure in which a first organic layer, a first barrier layer, a second organic layer, and a second barrier layer are sequentially stacked. Each of the first barrier layer and the second barrier layer may include an inorganic material such as silicon oxide. Each of the first organic layer and the second organic layer may include an organic insulating material such as a polyimide-based resin, and may have flexibility.

However, although the substrate 110 has been described as having four layers, the configuration of the substrate 110 is not limited thereto. In an embodiment, for example, the substrate 110 may have a single layer or a plurality of layers.

The functional module FM may be disposed in the module-corresponding area 20, on the lower surface of the substrate 110 which is furthest from the various emission structures. The functional module FM may directly contact the lower surface of the substrate 110. As being in direct contact, elements may form an interface or boundary therebetween, without being limited thereto. In an embodiment, for example, the functional module FM may include the camera module. The camera module may collect light incident from outside of the display device 100, and the display device 100 may obtain an image from the camera module.

The buffer layer 120 may be disposed on the substrate 110. That is, the buffer layer 120 may be disposed in an entirety of the display area 10 and an entirety of the module-corresponding area 20. The buffer layer 120 may prevent diffusion of metal atoms or impurities from the substrate 110 to the semiconductor element 200. In addition, when a surface of the substrate 110 is not uniform, the buffer layer 120 may serve to improve the flatness of the surface of the substrate 110. In an embodiment, for example, the buffer layer 120 may include silicon oxide (SiOₓ), silicon nitride (SiNₓ), and the like. These may be used alone or in combination with each other. In an embodiment, the buffer layer 120 may be disposed only in the display area 10 and may not be disposed in the module-corresponding area 20.

The active layer 130 may be disposed in the display area 10, on the buffer layer 120. Specifically, the active layer 130 may be disposed in the second pixel area 50 included in the display area 10. The active layer 130 may include a metal oxide semiconductor, an inorganic semiconductor (e.g., amorphous silicon, polysilicon) or an organic semiconductor. The active layer 130 may have a source region, a drain region, and a channel region positioned between the source region and the drain region in a direction along the substrate 110.

In an embodiment, the etch stop layer 135 may be disposed in the module-corresponding area 20, on the buffer layer 120. The etch stop layer 135 may be disposed in an entirety of the module-corresponding area 20. In addition, the etch stop layer 135 may be disposed on the same layer as the active layer 130. That is, the etch stop layer 135 may include the same material as the active layer 130. As being on a same layer, elements may be in a same layer as each other as respective portions of a same material layer, may form an interface with a same underlying or overlying layer, etc., without being limited thereto.

The etch stop layer 135 may include a transparent material. In an embodiment, the etch stop layer 135 may include indium gallium zinc oxide ("IGZO"), amorphous silicon, and the like. These may be used alone or in combination with each other. However, the material included in the etch stop layer 135 is not limited thereto, and the etch stop layer 135 may include other transparent materials.

In an embodiment, an etch rate of the etch stop layer 135 may be smaller than an etch rate of the phase compensation layer 175, which will be described later.

At least one inorganic insulating layer (e.g., the first gate insulating layer 141) may be disposed in the display area 10 on the buffer layer 120. The first gate insulating layer 141 may cover the active layer 130 in the display area 10 and may not be disposed in the module-corresponding area 20. In an embodiment, for example, the first gate insulating layer 141 may sufficiently cover the active layer 130 on the buffer layer 120, and may have a substantially flat top surface without creating a step around the active layer 130. In an embodiment, the first gate insulating layer 141 may cover the active layer 130 on the buffer layer 120, and may be disposed along a profile of the active layer 130 with a uniform thickness.

The first gate insulating layer 141 may include an inorganic insulating material. In an embodiment, for example, the first gate insulating layer 141 may include silicon oxide (SiOₓ), silicon nitride (SiNₓ), silicon carbide (SiCₓ), silicon oxynitride (SiOₓN_{y}), silicon oxycarbide (SiOₓC_{y}), and the like. These may be used alone or in combination with each other.

The first gate electrode 150 may be disposed in the display area 10 on the first gate insulating layer 141. Specifically, the first gate electrode 150 may be disposed in the second pixel area 50 included in the display area 10. The first gate electrode 150 may overlap the channel region of the active layer 130. In an embodiment, for example, the first gate electrode 150 may include a metal, an alloy, a metal nitride, a conductive metal oxide, a transparent conductive material, and the like. These may be used alone or in combination with each other.

At least one inorganic insulating layer (e.g., the second gate insulating layer 142) may be disposed in the display area 10 on the first gate insulating layer 141. The second gate insulating layer 142 may cover the first gate electrode 150 in the display area 10 and may not be disposed in the module-corresponding area 20. In an embodiment, for example, the second gate insulating layer 142 may sufficiently cover the first gate electrode 150 on the first gate insulating layer 141 and may have a substantially flat top surface without generating a step difference around the first gate electrode 150. In an embodiment, the second gate insulating layer 142 may cover the first gate electrode 150 on the first gate insulating layer 141 and may be disposed along a profile of the first gate electrode 150 with a uniform thickness.

The second gate insulating layer 142 may include an inorganic insulating material. In an embodiment, for example, the second gate insulating layer 142 may include silicon oxide, silicon nitride, silicon carbide, silicon oxynitride, silicon oxycarbide, and the like. These may be used alone or in combination with each other.

The second gate electrode 160 may be disposed in the display area 10, on the second gate insulating layer 142. Specifically, the second gate electrode 160 may be disposed in the second pixel area 50 included in the display area 10. The second gate electrode 160 may overlap the first gate electrode 150. The first gate electrode 150 and the second gate electrode 160 may function together as a capacitor. In an embodiment, for example, the second gate electrode 160 may include a metal, an alloy, a metal nitride, a conductive metal oxide, a transparent conductive material, and the like. These may be used alone or in combination with each other.

The interlayer insulating layer 170 may be disposed in the display area 10, on the second gate insulating layer 142. The interlayer insulating layer 170 may cover the second gate electrode 160 in the display area 10. In an embodiment, for example, the interlayer insulating layer 170 may sufficiently cover the second gate electrode 160 on the second gate insulating layer 142 and may have a substantially flat top surface without creating a step around the second gate electrode 160. In an embodiment, the interlayer insulating layer 170 may cover the second gate electrode 160 on the second gate insulating layer 142 and may be disposed along the profile of the second gate electrode 160 with a uniform thickness.

The interlayer insulating layer 170 may include an inorganic insulating material. In an embodiment, for example, the insulating interlayer 170 may include silicon oxide, silicon nitride, silicon carbide, silicon oxynitride, silicon oxycarbide, and the like. These may be used alone or in combination with each other. Here, the interlayer insulating layer 170 may be referred to as an inorganic insulating layer.

In a conventional display device, a phase difference between a first light L1 passing through a portion overlapping with a signal line 185, and a second light L2 passing through a portion not overlapping with the signal line 185, among the lights incident on a conventional module-corresponding area in which a functional member (e.g., a camera module) is disposed may occur. In this case, a flare phenomenon in which an image photographed by the camera module appears blurry may occur.

According to the invention, the phase compensation layer 175 is disposed in the module-corresponding area 20, on the etch stop layer 135. Specifically, the phase compensation layer 175 may be disposed in the transparent area 21 included in the module-corresponding area 20. The phase compensation layer 175 (e.g., light phase compensation layer) serves to compensate for the phase difference between a first light L1 passing through a portion overlapping the signal line 185, and a second light L2 passing through a portion not overlapping the signal line 185 (e.g., adjacent to or spaced apart from the signal line 185), among the lights incident on the module-corresponding area 20 (e.g., external light). Accordingly, an occurrence of the flare phenomenon may be reduced.

The phase compensation layer 175 includes the same material as the interlayer insulating layer 170. That is, the phase compensation layer 175 includes an inorganic insulating material. In an embodiment, the phase compensation layer 175 may include silicon oxide, silicon nitride, and the like. When the phase compensation layer 175 includes silicon oxide, a refractive index of the phase compensation layer 175 may be about 1.5 in a visible light region. When the phase compensation layer 175 includes silicon nitride, a refractive index of the phase compensation layer 175 may be about 1.8 to about 2.0 in a visible light region.

The source electrode 180 and the drain electrode 190 may be disposed in the display area 10, on the interlayer insulating layer 170. Specifically, the source electrode 180 and the drain electrode 190 may be disposed in the second pixel area 50 included in the display area 10. The source electrode 180 may be connected to the source region of the active layer 130 through a first contact hole formed by (or provided by) removing first portions of the first gate insulating layer 141, the second gate insulating layer 142 and the interlayer insulating layer 170. The drain electrode 190 may be connected to the drain region of the active layer 130 through a second contact hole formed by removing second portions of the first gate insulating layer 141, the second gate insulating layer 142 and the interlayer insulating layer 170. Each of the source electrode 180 and the drain electrode 190 may include a metal, an alloy, a metal nitride, a conductive metal oxide, a transparent conductive material, and the like. These may be used alone or in combination with each other.

The signal line 185 is disposed on the phase compensation layer 175. The signal line 185 overlaps the phase compensation layer 175. As shown in FIG. 5, the signal line 185 may be electrically connected to the first lower electrode 225 through a contact hole formed by removing a portion of the planarization layer 210 positioned in the module-corresponding area 20. The signal line 185 may extend from the module-corresponding area 20 to the pixel circuit area 30, to be electrically connected to the first pixel circuit structure 501. That is, the signal line 185 connects the first emission structure 300 to the pixel circuit area 30.

A thickness of the signal line 185 along the thickness direction, may be smaller than a thickness of each of the source electrode 180 and the drain electrode 190. In an embodiment, for example, the signal line 185 may be substantially transparent.

The signal line 185 may include a conductive metal oxide, a transparent conductive material, and the like. Examples of materials that can be used for the signal line 185 may be indium tin oxide ("ITO"), indium zinc oxide ("IZO"), indium gallium oxide ("IGO"), tin oxide ("SnO₂"), zinc oxide ("ZnO"), and the like. These may be used alone or in combination with each other. In an embodiment, the signal line 185 may include indium tin oxide. When the signal line 185 includes indium tin oxide, the refractive index of the signal line 185 may be about 1.9 or more in a visible light region.

The planarization layer 210 may be disposed on the source electrode 180 and drain electrode 190 disposed in the display area 10 and on the etch stop layer 135 disposed in the module-corresponding area 20. That is, the planarization layer 210 may extend from the display area 10 to the module-corresponding area 20. The planarization layer 210 may cover the source electrode 180 and the drain electrode 190 in the display area 10, and may cover the phase compensation layer 175 and the signal line 185 in the module-corresponding area 20. The planarization layer 210 may have a relatively large thickness. The planarization layer 210 may include an organic insulating material or an inorganic insulating material. In an embodiment, the planarization layer 210 may include an organic insulating material. Examples of the organic insulating material that can be used for the planarization layer 210 may be a photoresist, a polyacrylic resin, a polyimide-based resin, a polyamide-based resin, a siloxane-based resin, an acrylic resin, an epoxy-based resin, and the like. These may be used alone or in combination with each other. Where the planarization layer 210 includes a substantially transparent siloxane-based resin, the planarization layer 210 may be referred to as an organic insulating layer.

In an embodiment, a refractive index of the planarization layer 210 may be greater than a refractive index of the phase compensation layer 175 and less than that of the signal line 185. In an embodiment, for example, a refractive index of the planarization layer 210 may be about 1.65 in a visible light region. In this case, the phase compensation layer 175 may include silicon oxide, and the signal line 185 may include indium tin zinc oxide.

The second lower electrode 220 may be disposed in the display area 10, on the planarization layer 210. Specifically, the second lower electrode 220 may be disposed in the second pixel area 50 included in the display area 10. The second lower electrode 220 may be connected to the drain electrode 190 through a contact hole formed by removing a portion of the planarization layer 210. The second lower electrode 220 may be electrically connected to the semiconductor element 200. The second lower electrode 220 may include a metal, an alloy, a metal nitride, a conductive metal oxide, a transparent conductive material, and the like. These may be used alone or in combination with each other. For example, the second lower electrode 220 may have a stacked structure of ITO/Ag/ITO.

The first lower electrode 225 may be disposed in the module-corresponding area 20, on the planarization layer 210. Specifically, the first lower electrode 225 may be disposed in the first pixel area 40 included in the module-corresponding area 20. As described above, the first lower electrode 225 may be connected to the signal line 185 through a contact hole formed by removing a portion of the planarization layer 210 (see FIG. 5). The first lower electrode 225 may include a metal, an alloy, a metal nitride, a conductive metal oxide, a transparent conductive material, and the like. These may be used alone or in combination with each other. In addition, the first lower electrode 225 may have the same structure as the second lower electrode 220. In an embodiment, the first lower electrode 225 may have a structure different from a structure of the second lower electrode 220.

The pixel defining layer 250 may be disposed on a portion of the display area 10 and a portion of the module-corresponding area 20, on the planarization layer 210. That is, the pixel defining layer 250 may not be disposed in the transparent area 21. The pixel defining layer 250 may expose a portion of the second lower electrode 220 in the display area 10 to outside the pixel defining layer 250, and may expose a portion of the first lower electrode 225 in the module-corresponding area 20 to outside the pixel defining layer 250. In addition, an opening OP exposing layers in the transparent area 21 to outside the pixel defining layer 250 may be formed in (or defined by) the pixel defining layer 250. The pixel defining layer 250 may include an organic insulating material or an inorganic insulating material. In an embodiment, the pixel defining layer 250 may include an organic insulating material.

The second emission layer 230 may be disposed on the second lower electrode 220. The first emission layer 235 may be disposed on the first lower electrode 225. Each of the first emission layer 235 and the second emission layer 230 may be formed using at least one of emission materials that emit different color lights (e.g., red light, green light, blue light, and the like) according to sub-pixels.

The upper electrode 240 may be disposed in an entirety of the display area 10 and the module-corresponding area 20, on the substrate 110. The upper electrode 240 may be disposed along the profile of the first emission layer 235, the second emission layer 230, and the pixel defining layer 250. The upper electrode 240 may include a metal, an alloy, a metal nitride, a conductive metal oxide, a transparent conductive material, and the like. These may be used alone or in combination with each other.

The first inorganic thin film encapsulation layer 261 may be disposed on the upper electrode 240. The first inorganic thin film encapsulation layer 261 may be disposed in an entirety of the display area 10 and an entirety of the module-corresponding area 20. The first inorganic thin film encapsulation layer 261 may prevent (or reduce) the first emission structure 300 and the second emission structure 400 from being deteriorated due to penetration of moisture, oxygen, and the like. In addition, the first inorganic thin film encapsulation layer 261 may also function to protect the first emission structure 300 and the second emission structure 400 from external impact. In an embodiment, for example, the first inorganic thin film encapsulation layer 261 may include an inorganic insulating material having flexibility.

The organic thin film encapsulation layer 262 may be disposed on the first inorganic thin film encapsulation layer 261. The organic thin film encapsulation layer 262 may be disposed in an entirety of the display area 10 and the module-corresponding area 20. The organic thin film encapsulation layer 262 may improve the flatness of the display device 100, and may protect the first emission structure 300 and the second emission structure 400 together with the first inorganic thin film encapsulation layer 261. The organic thin film encapsulation layer 262 may include an organic insulating material having flexibility.

The second inorganic thin film encapsulation layer 263 may be disposed on the organic thin film encapsulation layer 262. The second inorganic thin film encapsulation layer 263 may be disposed in an entirety of the display area 10 and an entirety of the module-corresponding area 20. The second inorganic thin film encapsulation layer 263 may be used together with the first inorganic thin film encapsulation layer 261 to prevent the first emission structure 300 and the second emission structure 400 from being deteriorated due to penetration of moisture, oxygen, and the like.

In addition, the second inorganic thin film encapsulation layer 263 may also perform a function to protect the first emission structure 300 and the second emission structure 400 together with the first inorganic thin film encapsulation layer 261 and the organic thin film encapsulation layer 262 from external impact. In an embodiment, for example, the second inorganic thin film encapsulation layer 263 may include an inorganic insulating material having flexibility.

In one or more embodiments of the display device 100, as the phase compensation layer 175 including an inorganic insulating material is disposed in the module-corresponding area 20, on the etch stop layer 135, an occurrence of the flare phenomenon may be reduced.

However, in a relatively large area display device, in the process of patterning the phase compensation layer 175, a thickness of the phase compensation layer 175 may become non-uniform.

In one or more embodiments of the display device 100, as the etch stop layer 135 including a transparent material is disposed in the module-corresponding area 20, between the substrate 110 and the phase compensation layer 175, a thickness non-uniformity of the phase compensation layer 175 in the large area display device may be improved.

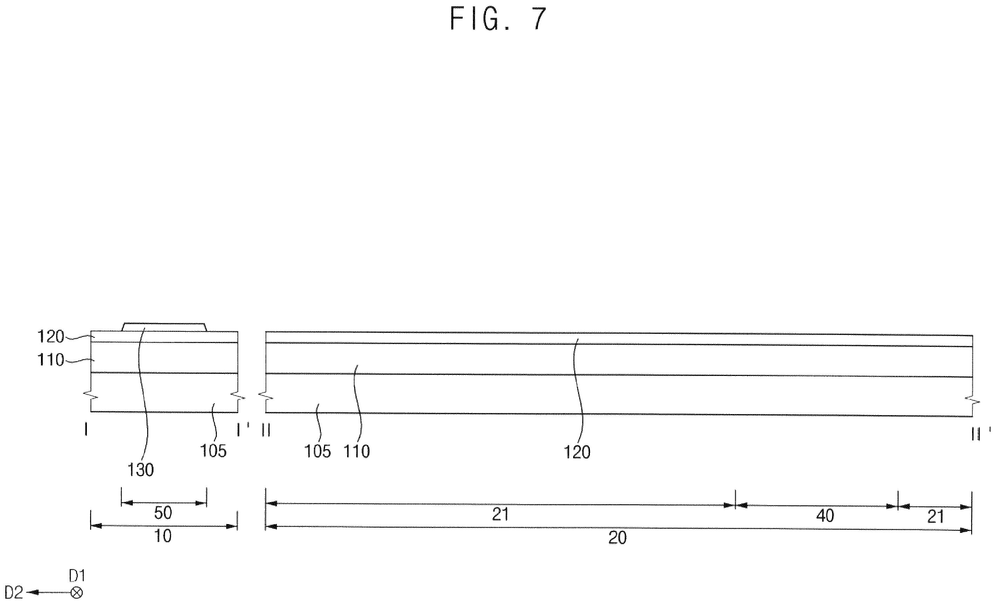

FIG. 7, 8, 9, 10, 11, 12, 13, 14, 15, and 16 are cross-sectional views illustrating embodiments of structures in a method of manufacturing (or providing) the display device 100 of FIG. 6.

Referring to FIG. 7, the substrate 110 including a transparent material may be formed on a rigid glass substrate 105 (e.g., a base layer). The substrate 110 may be formed using a flexible transparent resin substrate. In an embodiment, the substrate 110 may be formed using a quartz substrate, a synthetic quartz substrate, a glass substrate, and the like. In this case, the rigid glass substrate 105 may be omitted.

In an embodiment, for example, when the substrate 110 includes a transparent material, since the substrate 110 is thin and flexible, the substrate 110 may be formed on the rigid glass substrate 105 to support the formation of the semiconductor element 200, the first emission structure 300, the second emission structure 400, and the thin film encapsulation structure 260, and the like. As will be described later, after the thin film encapsulation structure 260 is formed, the rigid glass substrate 105 may be removed.

The substrate 110 may include the display area 10, the module-corresponding area 20, and the pixel circuit area 30.

The buffer layer 120 may be formed on the substrate 110. The buffer layer 120 may be formed in an entirety of the display area 10 and an entirety of the module-corresponding area 20. According to the type of the substrate 110, two or more buffer layers 120 may be formed on the substrate 110 or the buffer layer 120 may not be formed. The buffer layer 120 may be formed using silicon oxide, silicon nitride, and the like.

The active layer 130 may be formed in the display area 10 on the buffer layer 120. The active layer 130 may be formed using a metal oxide semiconductor, an inorganic semiconductor, or an organic semiconductor. The active layer 130 may include a source region, a drain region, and a channel region positioned between the source region and the drain area.

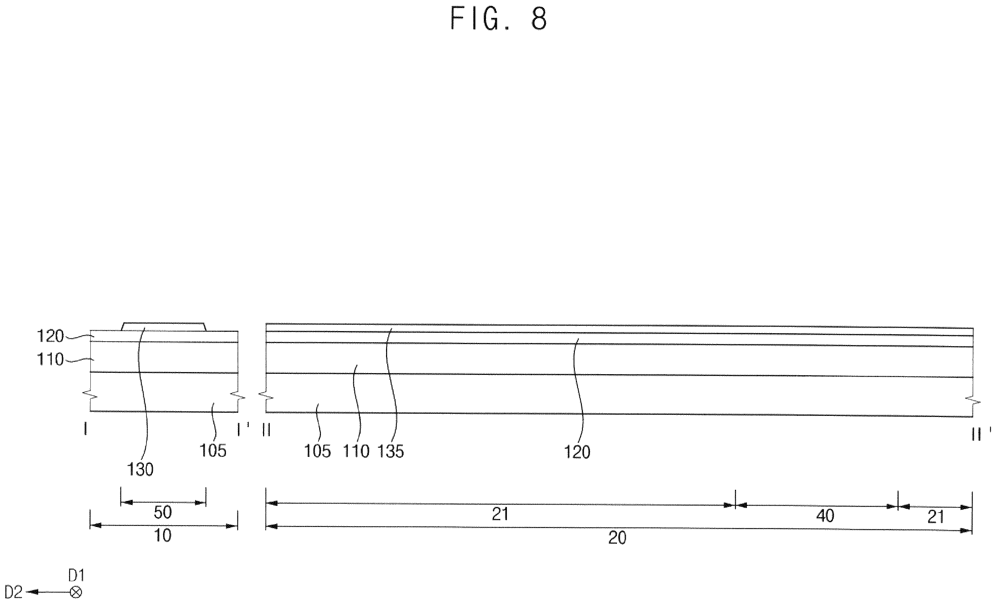

Referring to FIG. 8, the etch stop layer 135 may be formed in the module-corresponding area 20, on the buffer layer 120. That is, the etch stop layer 135 may be formed on the same layer as the active layer 130. In addition, the etch stop layer 135 may be formed in an entirety of the module-corresponding area 20. In an embodiment, for example, the etch stop layer 135 may be formed using a transparent material. In an embodiment, the etch stop layer 135 may be formed using indium gallium zinc oxide, amorphous silicon, and the like.

The etch stop layer 135 may be formed in the same process as the active layer 130. That is, the etch stop layer 135 may be simultaneously formed using the same material as the active layer 130. In an embodiment, the etch stop layer 135 may be formed in a process different from a process of the active layer 130. In an embodiment, for example, after the active layer 130 is formed, the etch stop layer 135 may be formed. In this case, the etch stop layer 135 may be formed using a material different from a material of the active layer 130.

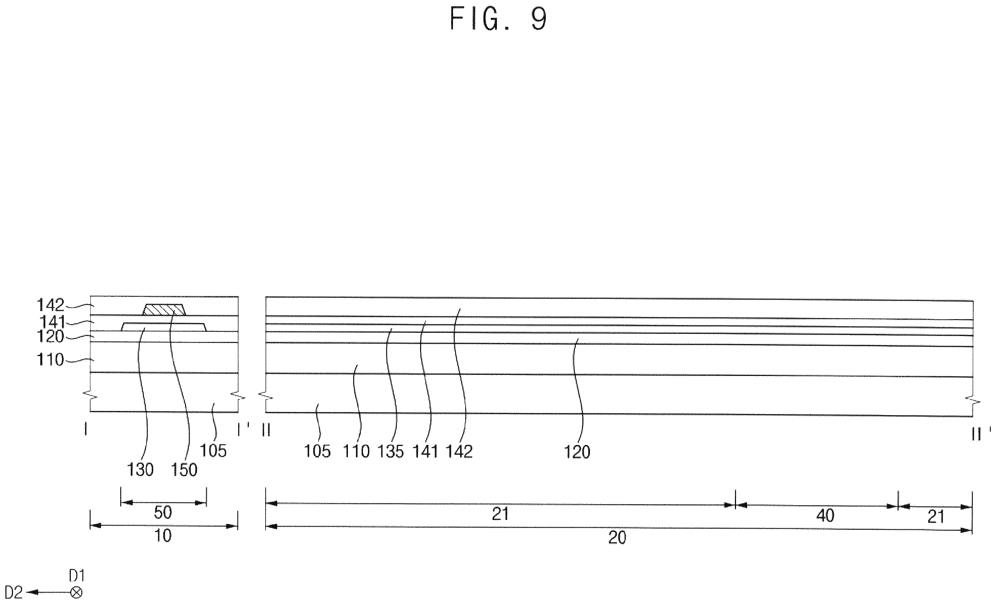

Referring to FIG. 9, the first gate insulating layer 141 may be formed on the buffer layer 120. The first gate insulating layer 141 may cover the active layer 130 in the display area 10 and may extend to the module-corresponding area 20. That is, the first gate insulating layer 141 may be formed in an entirety of the display area 10 and an entirety of the module-corresponding area 20. The first gate insulating layer 141 may be formed using silicon oxide, silicon nitride, silicon oxynitride, and the like.

The first gate electrode 150 may be formed in the display area 10 on the first gate insulating layer 141. The first gate electrode 150 may be formed to overlap the channel region of the active layer 130. The first gate electrode 150 may be formed using a metal, an alloy, a metal nitride, a conductive metal oxide, a transparent conductive material, and the like.

The second gate insulating layer 142 may be formed on the first gate insulating layer 141. The second gate insulating layer 142 may cover the first gate electrode 150 in the display area 10 and may extend to the module-corresponding area 20. That is, the second gate insulating layer 142 may be formed in an entirety of the display area 10 and an entirety of the module-corresponding area 20. The second gate insulating layer 142 may be formed using silicon oxide, silicon nitride, silicon oxynitride, and the like.

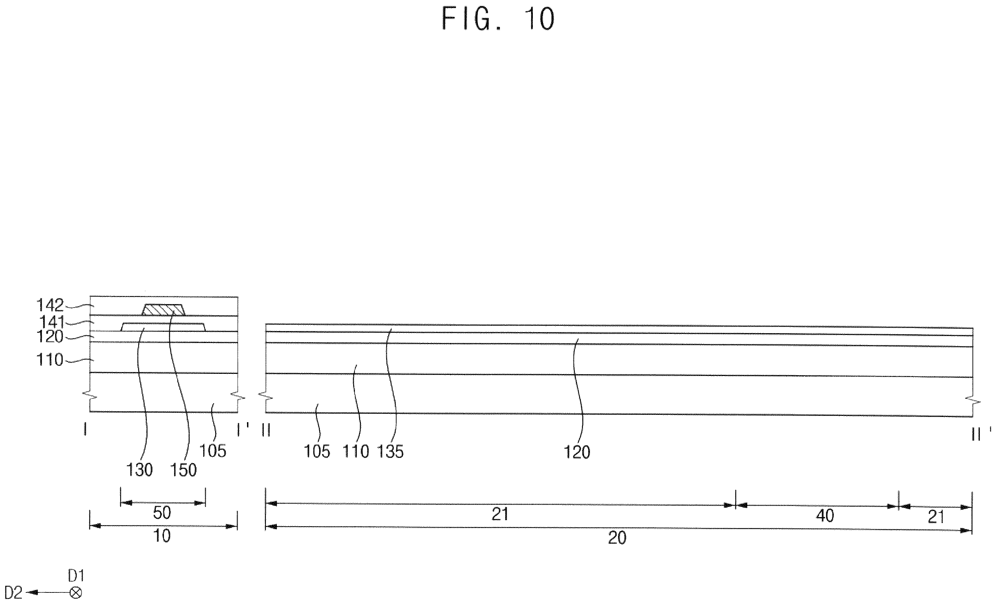

Referring to FIG. 10, the first gate insulating layer 141 and the second gate insulating layer 142 disposed in the module-corresponding area 20 may be removed. Removal of the first gate insulating layer 141 and the second gate insulating layer 142 from the module-corresponding area 20 exposes the etch stop layer 135 to outside the first gate insulating layer 141 and the second gate insulating layer 142.

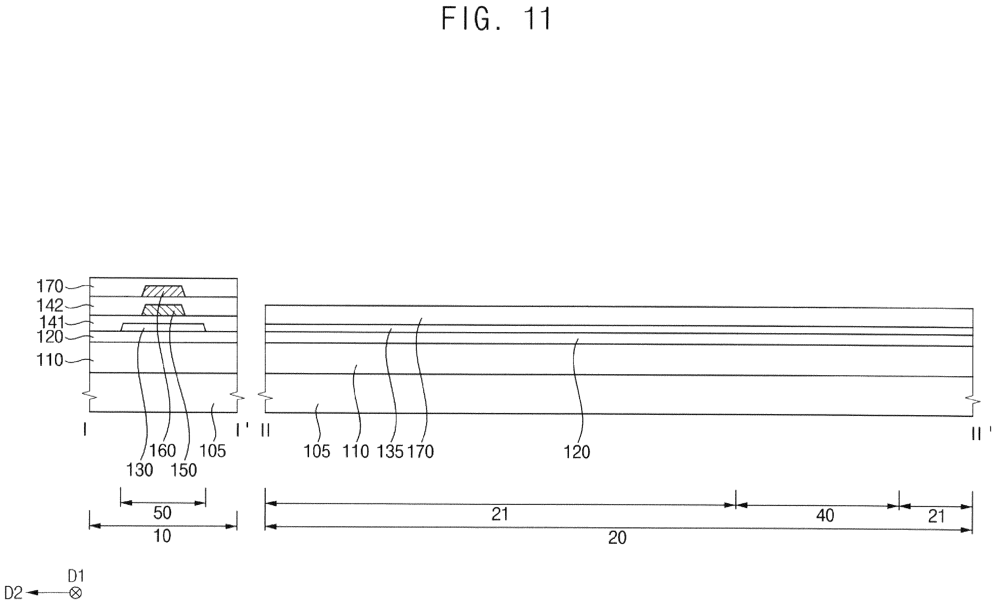

Referring to FIG. 11, the second gate electrode 160 may be formed in the display area 10, on the second gate insulating layer 142. The second gate electrode 160 may overlap the first gate electrode 150. The second gate electrode 160 may be formed using a metal, an alloy, a metal nitride, a conductive metal oxide, a transparent conductive material, and the like.

The interlayer insulating layer 170 may be disposed on the second gate insulating layer 142. The interlayer insulating layer 170 may cover the second gate electrode 160 in the display area 10 and may extend to the module-corresponding area 20. That is, the interlayer insulating layer 170 may be formed in an entirety of the display area 10 and an entirety of the module-corresponding area 20. The interlayer insulating layer 170 may be formed using silicon oxide, silicon nitride, silicon oxynitride, and the like.

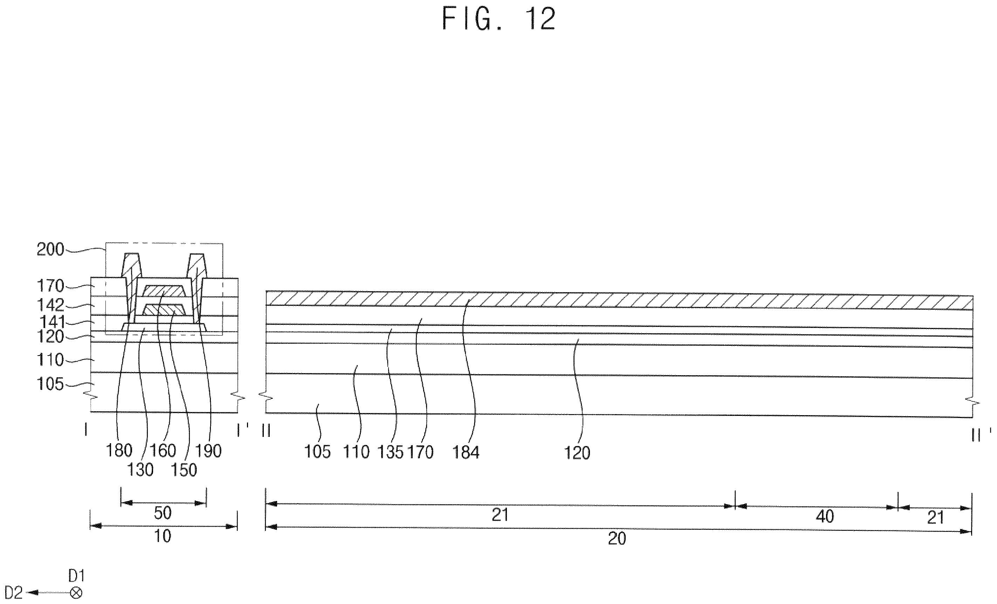

Referring to FIG. 12, the source electrode 180 and the drain electrode 190 may be formed in the display area 10 on the interlayer insulating layer 170. The source electrode 180 may be connected to the source region of the active layer 130 through a first contact hole formed by removing a first portion of each of the first gate insulating layer 141, the second gate insulating layer 142 and the interlayer insulating layer 170. The drain electrode 190 may be connected to the drain region of the active layer 130 through a second contact hole formed by removing a second portion of each of the first gate insulating layer 141, the second gate insulating layer 142 and the interlayer insulating layer 170. Each of the source electrode 180 and the drain electrode 190 may be formed using a metal, an alloy, a metal nitride, a conductive metal oxide, a transparent conductive material, and the like.

Accordingly, the semiconductor element 200 including the active layer 130, the first gate electrode 150, the second gate electrode 160, the source electrode 180 and the drain electrode 190, may be formed in the second pixel area 50.

A conductive film 184 may be formed in the module-corresponding area 20, on the interlayer insulating layer 170. The conductive film 184 may be formed using a conductive metal oxide, a transparent conductive material, and the like. In an embodiment, for example, the conductive film 184 may be formed using ITO, IZO, IGO, SnO₂, ZnO, and the like.

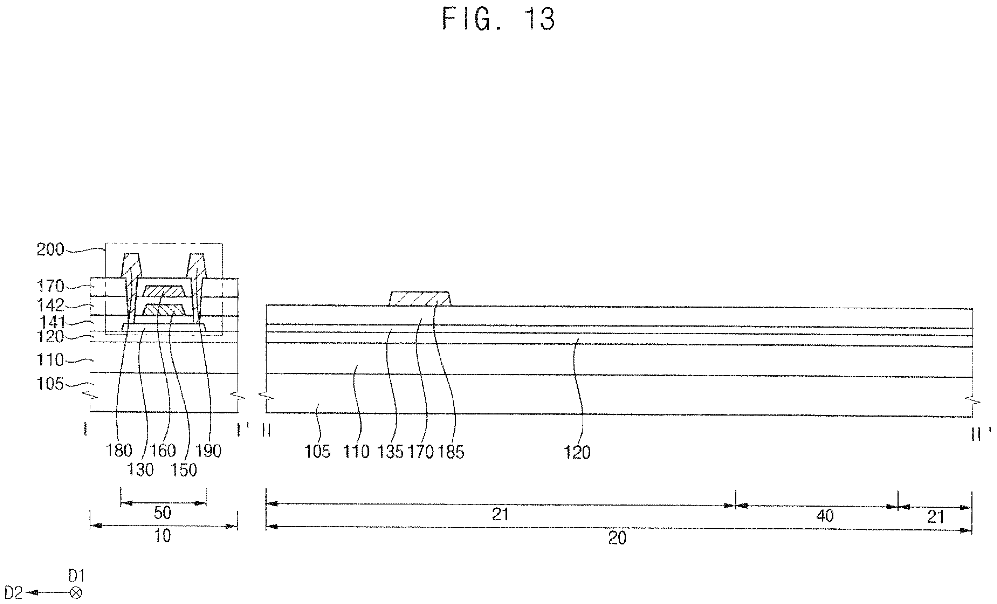

Referring to FIGS. 12 and 13, the signal line 185 may be formed by patterning the conductive film 184 (e.g., signal line material layer). In an embodiment, the signal line 185, the source electrode 180, and the drain electrode 190 may be formed on the same layer, but is not limited thereto, and may be formed in different processes using different materials from each other. In an embodiment, for example, after the source electrode 180 and the drain electrode 190 are formed, the signal line 185 may be formed.

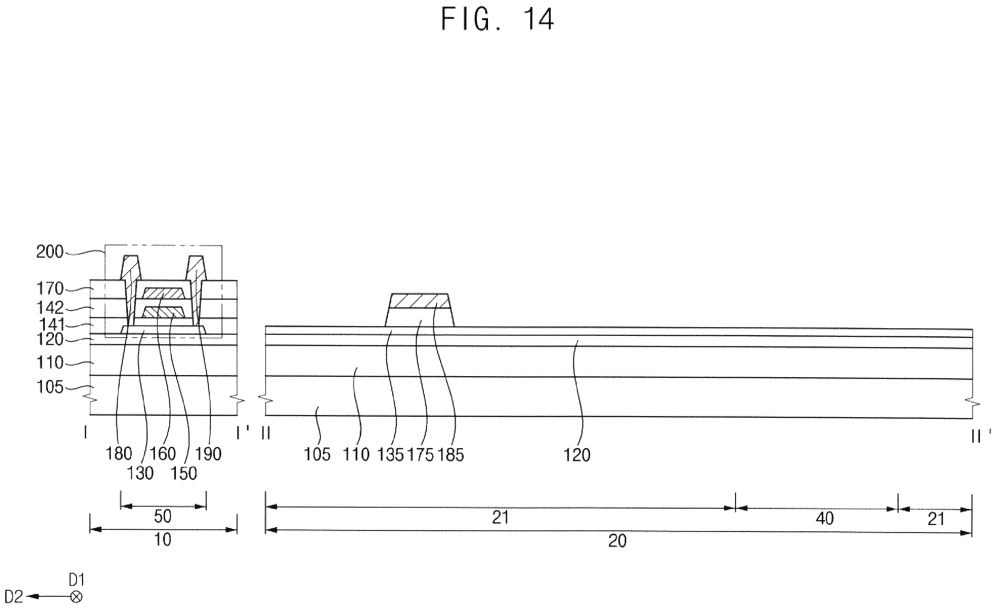

Referring to FIGS. 13 and 14, the phase compensation layer 175 may be formed by patterning the interlayer insulating layer 170 disposed in the module-corresponding area 20. Specifically, the phase compensation layer 175 may be formed at a location corresponding to the signal line 185, using the signal line 185 as a mask. That is, after the phase compensation layer 175 (e.g., phase compensation pattern) is formed, an upper surface of the etch stop layer 135 that does not overlap the signal line 185 in the module-corresponding area 20, may be exposed to outside the interlayer insulating layer 170 (or the phase compensation pattern) and the signal line 185. However, in an embodiment, a portion of the interlayer insulating layer 170 that does not overlap the signal line 185 may remain in the module-corresponding area 20.

In an embodiment, for example, the phase compensation layer 175 may be formed using silicon oxide, silicon nitride, and the like. That is, the phase compensation layer 175 may be formed using the same material as the interlayer insulating layer 170.

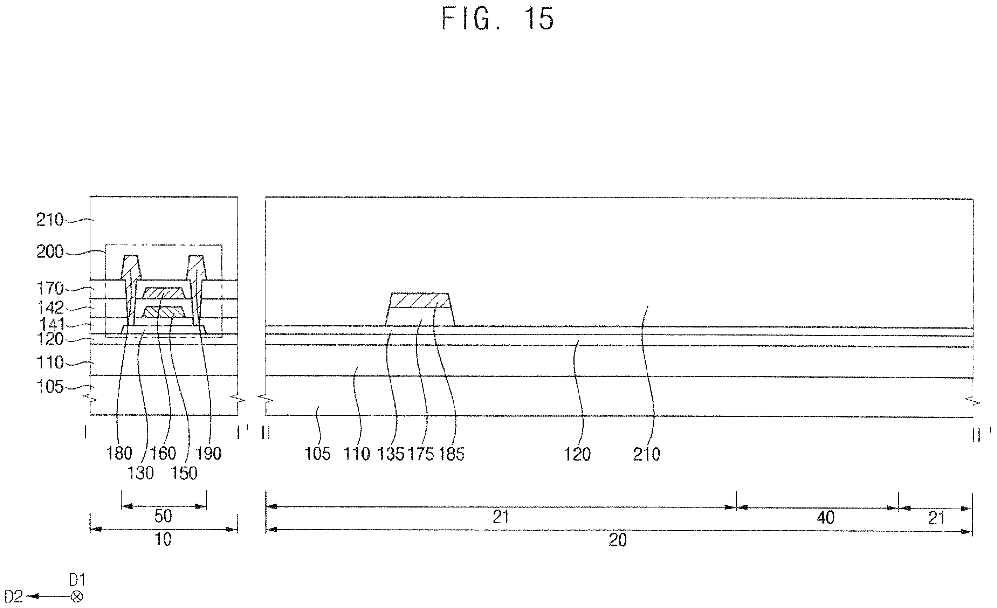

Referring to FIG. 15, the planarization layer 210 may be formed on the interlayer insulating layer 170 and the etch stop layer 135. That is, the planarization layer 210 may cover the source electrode 180 and the drain electrode 190 in the display area 10 and may extend to the module-corresponding area 20. The planarization layer 210 may cover the phase compensation layer 175 and the signal line 185 in the module-corresponding area 20. The planarization layer 210 may be formed using a photoresist, a polyacrylic resin, a polyimide-based resin, a polyamide-based resin, a siloxane-based resin, an acrylic resin, an epoxy-based resin, and the like. The planarization layer 210 may be formed using a substantially transparent siloxane-based resin.

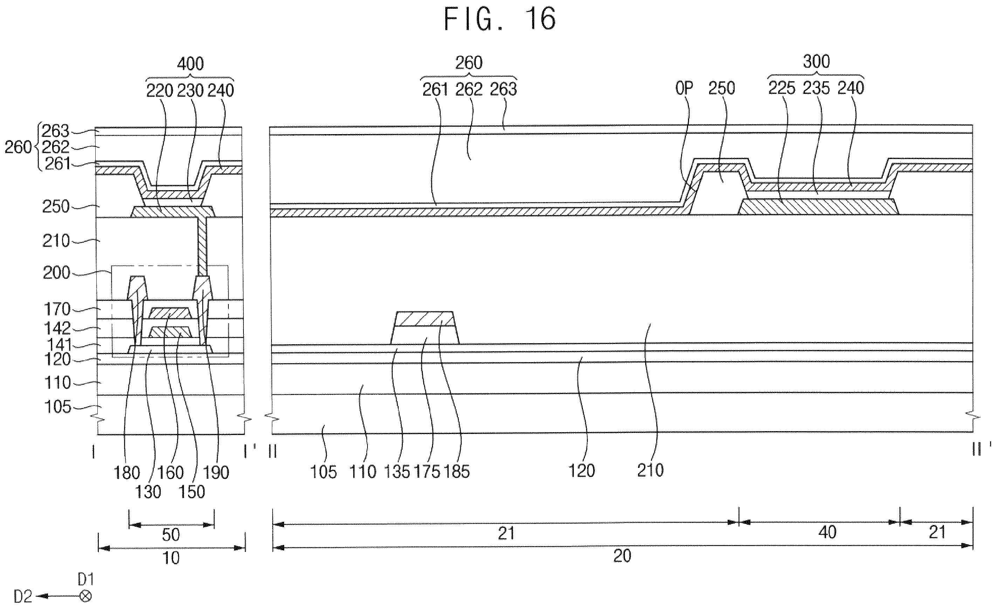

Referring to FIG. 16, the second lower electrode 220 may be formed in the display area 10, on the planarization layer 210. The first lower electrode 225 may be formed in the module-corresponding area 20, on the planarization layer 210. The second lower electrode 220 may be connected to the drain electrode 190 through a contact hole formed by removing a portion of the planarization layer 210. The first lower electrode 225 may be connected to the signal line 185 through a contact hole formed by removing a portion of the planarization layer 210 (see box surrounding 'x' in FIG. 5). Each of the first lower electrode 225 and the second lower electrode 220 may be formed using a metal, an alloy, a metal nitride, a conductive metal oxide, a transparent conductive material, and the like. In an embodiment, for example, each of the first lower electrode 225 and the second lower electrode 220 may have a stacked structure of ITO/Ag/ITO.

The pixel defining layer 250 may be formed in the display area 10 and a portion of the module-corresponding area 20, on the planarization layer 210. The pixel defining layer 250 may expose a portion of the second lower electrode 220 in the display area 10, and may expose a portion of the first lower electrode 225 in the module-corresponding area 20. In addition, the opening OP exposing layers in the transparent area 21 may be formed in the pixel defining layer 250. The pixel defining layer 250 may be formed using an organic insulating material.

The second emission layer 230 may be formed on the second lower electrode 220, and the first emission layer 235 may be formed on the first lower electrode 225. Each of the first emission layer 235 and the second emission layer 230 may be formed using at least one of light emitting materials capable of emitting light of different colors according to sub-pixels.

The upper electrode 240 may be formed in an entirety of the display area 10 and an entirety of the module-corresponding area 20 on the substrate 110. The upper electrode 240 may be formed along the profile of the first emission layer 235, the second emission layer 230, and the pixel defining layer 250. The upper electrode 240 may be formed using a metal, an alloy, a metal nitride, a conductive metal oxide, a transparent conductive material, and the like.

Accordingly, the second emission structure 400 including the second lower electrode 220, the second emission layer 230 and the upper electrode 240 may be formed in the second pixel area 50, and the first emission structure 300 including the first lower electrode 225, the first emission layer 235 and the upper electrode 240 may be formed in the first pixel area 40.

The first inorganic thin film encapsulation layer 261 may be formed in the display area 10 and the module-corresponding area 20, on the upper electrode 240. In an embodiment, for example, the first inorganic thin film encapsulation layer 261 may be formed using an inorganic insulating material having flexibility. The organic thin film encapsulation layer 262 may be formed in the display area 10 and the module-corresponding area 20, on the first inorganic thin film encapsulation layer 261. In an embodiment, for example, the organic thin film encapsulation layer 262 may be formed using an organic insulating material having flexibility. The second inorganic thin film encapsulation layer 263 may be formed on the organic thin film encapsulation layer 262. The second inorganic thin film encapsulation layer 263 may be formed using an inorganic insulating material having flexibility.

Accordingly, the thin film encapsulation structure 260 including the first inorganic thin film encapsulation layer 261, the organic thin film encapsulation layer 262, and the second inorganic thin film encapsulation layer 263 may be formed. After the thin film encapsulation structure 260 is formed, the glass substrate 105 may be removed from the substrate 110 to expose a lower surface of the substrate 110.

Referring back to FIG. 6, the functional module FM may be formed in the module-corresponding area 20, on the lower surface of the substrate 110. In an embodiment, for example, the functional module FM may include the camera module and the like.

Accordingly, the display device 100 shown in FIGS. 1, 2, 3, 4, 5, and 6 may be provided.

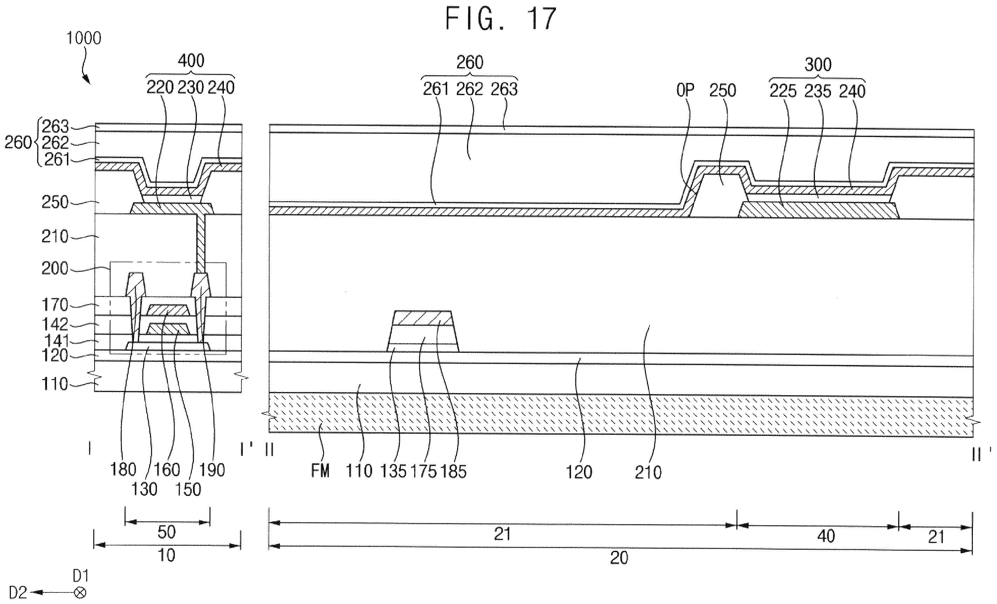

FIG. 17 is a cross-sectional view illustrating an embodiment of a display device 1000.

Referring to FIG. 17, the display device 1000 may include a functional module FM, a substrate 110, a buffer layer 120, a semiconductor element 200, a first gate insulating layer 141, a second gate insulating layer 142, an interlayer insulating layer 170, a phase compensation layer 175, a signal line 185, an etch stop layer 135, a planarization layer 210, a pixel defining layer 250, a first emission structure 300, a second emission structure 400 and a thin film encapsulation structure 260. The display device 1000 of FIG. 17 may be substantially the same as or similar to the display device 100 described with reference to FIG. 6 except for the etch stop layer 135. Hereinafter, overlapping descriptions will be omitted.

The etch stop layer 135 may be disposed in the module-corresponding area 20, on the buffer layer 120. In an embodiment, the etch stop layer 135 may be patterned to define an etch stop pattern which overlaps each of the phase compensation layer 175 and the signal line 185. In this case, the etch stop layer 135 may include amorphous silicon. The buffer layer 120 may be exposed to outside the phase compensation layer 175, the signal line 185 and the etch stop layer 135, within the module-corresponding area 20.

Although the etch stop layer 135 and the active layer 130 are formed on the same layer, the invention is not limited thereto, and the etch stop layer 135 and the active layer 130 may be formed using different materials and in different processes. In an embodiment, for example, after the active layer 130 is formed, the etch stop layer 135 may be formed. Specifically, after the phase compensation layer 175 is patterned to provide a phase compensation pattern, the etch stop layer 135 may be patterned to provide an etch stop pattern.

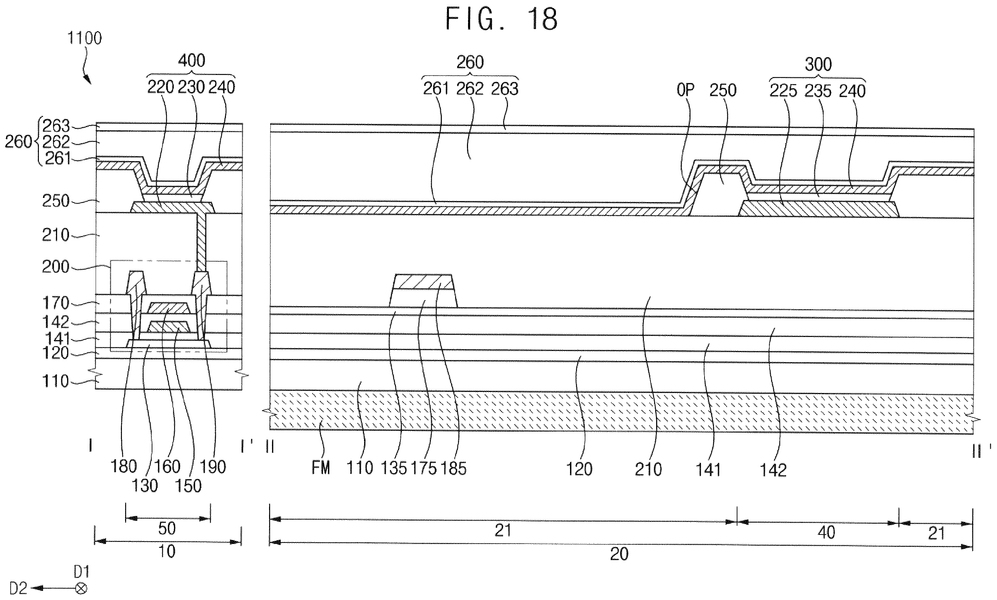

FIG. 18 is a cross-sectional view illustrating an embodiment of a display device 1100.

Referring to FIG. 18, the display device 1100 may include a functional module FM, a substrate 110, a buffer layer 120, a semiconductor element 200, a first gate insulating layer 141, a second gate insulating layer 142, an interlayer insulating layer 170, a phase compensation layer 175, a signal line 185, an etch stop layer 135, a planarization layer 210, a pixel defining layer 250, a first emission structure 300, a second emission structure 400, a thin film encapsulation structure 260. The display device 1100 of FIG. 18 may be substantially the same as or similar to the display device 100 described with reference to FIG. 6 except for the first gate insulating layer 141 and the second gate insulating layer 142 disposed in the module-corresponding area 20. Hereinafter, overlapping descriptions will be omitted.

At least one inorganic insulating layer (e.g., the first gate insulating layer 141, the second gate insulating layer 142, and the like) may be disposed on the buffer layer 120. In an embodiment, for example, the first gate insulating layer 141 may be disposed on the buffer layer 120, and the second gate insulating layer 142 may be disposed on the first gate insulating layer 141. In an embodiment, the first gate insulating layer 141 and the second gate insulating layer 142 may be disposed in an entirety of the display area 10 and an entirety of the module-corresponding area 20. That is, the first gate insulating layer 141 and the second gate insulating layer 142 in the module-corresponding area 20 may remain on the substrate 110, without being removed. In an embodiment, each of the first gate insulating layer 141 and the second gate insulating layer 142 may have a multilayer structure including a plurality of insulating layers.

The etch stop layer 135 may be disposed in the module-corresponding area 20, on the second gate insulating layer 142. In addition, the etch stop layer 135 may be disposed in an entirety of the module-corresponding area 20 to face the substrate with both the first gate insulating layer 141 and the second gate insulating layer 142 therebetween.

In an embodiment, the etch stop layer 135 may be formed in a process different from a process of the active layer 130. In an embodiment, for example, after the active layer 130 is formed, the etch stop layer 135 may be formed. In this case, the etch stop layer 135 and the active layer 130 may include different materials.

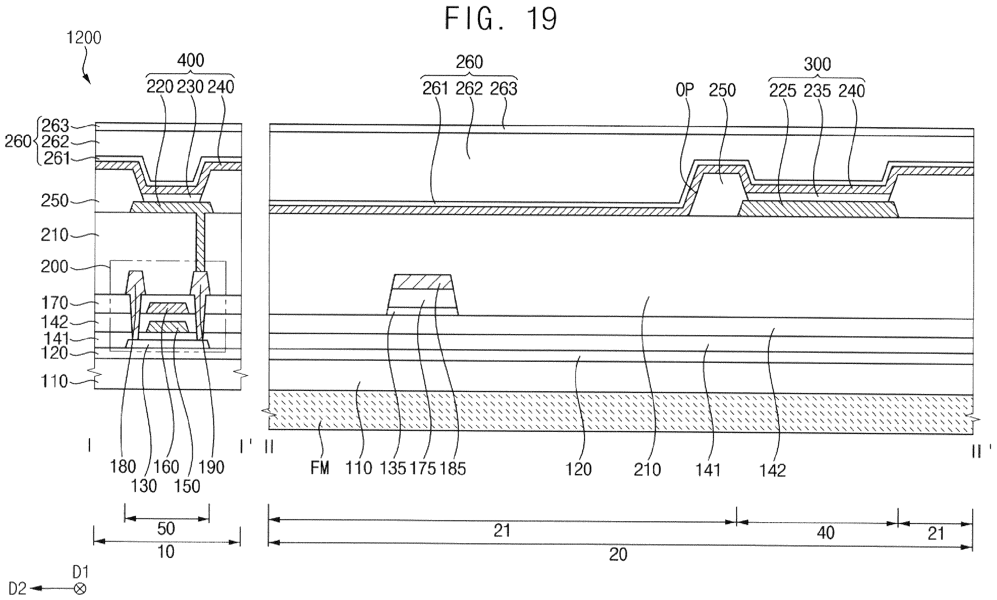

FIG. 19 is a cross-sectional view illustrating an embodiment of a display device 1200.

Referring to FIG. 19, the display device 1200 may include a functional module FM, a substrate 110, a buffer layer 120, a semiconductor element 200, a first gate insulating layer 141, and a second gate insulating layer 142, an interlayer insulating layer 170, a phase compensation layer 175, a signal line 185, an etch stop layer 135, a planarization layer 210, a pixel defining layer 250, a first emission structure 300, a second emission structure 400 and a thin film encapsulation structure 260. The display device 1200 of FIG. 19 may be substantially the same as or similar to the display device 1100 described with reference to FIG. 18 except for the etch stop layer 135 disposed in the module-corresponding area 20. Hereinafter, overlapping descriptions will be omitted.

The etch stop layer 135 may be disposed in the module-corresponding area 20, on the second gate insulating layer 142. In addition, referring back to FIG. 17, the etch stop layer 135 may be patterned to overlap each of the phase compensation layer 175 and the signal line 185.

One or more embodiment of the present disclosure can be applied to various display devices that may include an image-generating device. In an embodiment, for example, the present disclosure can be applied to high-resolution smartphones, mobile phones, smart pads, smart watches, tablet PCs, in-vehicle navigation systems, televisions, computer monitors, notebook computers, and the like.

The foregoing is illustrative of embodiments and is not to be construed as limiting thereof. Although embodiments have been described, those skilled in the art will readily appreciate that many modifications are possible in the embodiments without materially departing from the novel teachings and advantages of the invention. Accordingly, all such modifications are intended to be included within the scope of the invention as defined in the claims. Therefore, it is to be understood that the foregoing is illustrative of various embodiments and is not to be construed as limited to the embodiments disclosed, and that modifications to the disclosed embodiments, as well as other embodiments, are intended to be included within the scope of the appended claims.

## Claims

1. A display device (100, 1000, 1100, 1200) comprising:
a display area (10), a pixel circuit area (30) adjacent to the display area (10), and a functional module area (20) between the display area (10) and the pixel circuit area (30);
an inorganic insulating layer (170) in the display area (10);
a light phase compensation layer (175) in the functional module area (20) and including a same material as the inorganic insulating layer (170) of the display area (10);
a signal line (185) corresponding to the light phase compensation layer (175), in the functional module area (20), and extending from the functional module area (20) to the pixel circuit area (30); and
an organic insulating layer (210) facing the inorganic insulating layer (170), in the display area (10), and extending from the display area (10) to the functional module area (20) to face the light phase compensation layer (175) with the signal line (185) therebetween,
wherein the light phase compensation layer (175) compensates for the phase difference between a first light (L1) passing through a portion overlapping the signal line (185), and a second light (L2) passing through a portion not overlapping the signal line (185),
wherein both the first light (L1) and second light (L2) are external light, incident to the functional module area (20), and
wherein the signal line (185) overlaps the light phase compensation layer (175).

2. The display device (100, 1000, 1100, 1200) of claim 1, further comprising:
an etch stop layer (135) facing the signal line (185) with the light phase compensation layer (175) therebetween, in the functional module area (20), and
the etch stop layer (135) in the functional module area (20) including a transparent material.

3. The display device (100, 1000, 1100, 1200) of claim 2, wherein
each of the light phase compensation layer (175) and the etch stop layer (135) has an etch rate, and
the etch rate of the etch stop layer (135) is smaller than the etch rate of the light phase compensation layer (175).

4. The display device (100, 1000, 1100, 1200) of claim 2 or claim 3, wherein the etch stop layer (135) includes indium gallium zinc oxide or amorphous silicon.

5. The display device (100, 1100) of claim 4, wherein the etch stop layer (135) is in an entirety of the functional module area (20).

6. The display device (1000, 1200) of claim 4, wherein the etch stop layer (135) in the functional module area (20) defines an etch stop pattern spaced apart from the inorganic insulating layer (170) of the display area (10).

7. The display device (100, 1000, 1100, 1200) of any one of claims 1 to 6, wherein the signal line (185) includes a conductive metal oxide or a transparent conductive material, optionally wherein the transparent conductive material includes indium tin oxide, indium zinc oxide or indium gallium oxide.

8. The display device (100, 1000, 1100, 1200) of any one of claims 1 to 7, wherein the inorganic insulating layer (170) includes silicon oxide or silicon nitride.

9. The display device (100, 1000, 1100, 1200) of any one of claims 1 to 8, wherein within the functional module area (20),
each of the organic insulating layer (210), the light phase compensation layer (175) and the signal line (185) has a refractive index, and
the refractive index of the organic insulating layer (210) is greater than the refractive index of the light phase compensation layer (175) and smaller than the refractive index of the signal line (185), optionally wherein the refractive index of the signal line (185) is about 1.9 or more in a visible light region.

10. The display device (100, 1000, 1100, 1200) of any one of claims 1 to 9, further comprising within the functional module area (200):
a substrate (110) facing the signal line (185) with the light phase compensation layer (175) therebetween, and
a functional module (FM) which provides a function of the display device (100, 1000, 1100, 1200), with light, the functional module (FM) facing the light phase compensation layer (175) with the substrate (110) therebetween, optionally wherein the functional module (FM) includes a camera module, a face recognition sensor module, a pupil recognition sensor module, an acceleration sensor module, a proximity sensor module, an infrared sensor module or an illuminance sensor module.

11. The display device (100, 1000, 1100, 1200) of any one of claims 1 to 10, further comprising:
a pixel circuit structure (501) in the pixel circuit area (30) and including a semiconductor element (200); and
an emission structure in the functional module area (20) and connected to the pixel circuit structure (501) of the pixel circuit area (30), optionally wherein the signal line (185) electrically connects the pixel circuit structure (501) of the pixel circuit area (30) to the emission structure of the functional module area (20).

12. The display device (1100, 1200) of claim 1, comprising:
a functional module (FM) which provides a function of the display device (1100, 1200), with light;
wherein the inorganic insulating layer (170) is a first inorganic insulating layer (170) and the display device (1100, 1200) further comprises a second inorganic insulating layer (141, 142) in both the display area (10) and the functional module area (20); and
wherein in the functional module area (20), the organic insulating layer (210) faces the second inorganic insulating layer (141, 142) with each of the light phase compensation layer (175) and the signal line (185) therebetween.

13. The display device (1100, 1200) of claim 12, further comprising:
an etch stop layer (135) between the second inorganic insulating layer (141, 142) and the light phase compensation layer (175), in the functional module area (20), and
the etch stop layer (135) in the functional module area (20) including a transparent material.

14. The display device (1100, 1200) of claim 13, wherein
(i) each of the light phase compensation layer (175) and the etch stop layer (135) has an etch rate, and
the etch rate of the etch stop layer (135) is smaller than the etch rate of the light phase compensation layer (175); and/or
(ii) the etch stop layer (135) includes indium gallium zinc oxide or amorphous silicon.

15. The display device (1100, 1200) of any one of claims 12 to 14, wherein the second inorganic insulating layer (141, 142) includes silicon oxide or silicon nitride.

## Patentansprüche

1. Anzeigevorrichtung (100, 1000, 1100, 1200), umfassend:
einen Anzeigebereich (10), einen Pixelschaltungsbereich (30), der an den Anzeigebereich (10) angrenzt, und einen Funktionsmodulbereich (20) zwischen dem Anzeigebereich (10) und dem Pixelschaltungsbereich (30);
eine anorganische Isolierschicht (170) im Anzeigebereich (10);
eine Lichtphasen-Kompensationsschicht (175) im Funktionsmodulbereich (20), die ein gleiches Material wie die anorganische Isolierschicht (170) des Anzeigebereichs (10) einschließt;
eine Signalleitung (185) im Funktionsmodulbereich (20), die der Lichtphasen-Kompensationsschicht (175) entspricht und sich vom Funktionsmodulbereich (20) zum Pixelschaltungsbereich (30) erstreckt; und
eine organische Isolierschicht (210) im Anzeigebereich (10), die der anorganischen Isolierschicht (170) zugewandt ist und sich vom Anzeigebereich (10) zum Funktionsmodulbereich (20) erstreckt, sodass sie der Lichtphasen-Kompensationsschicht (175) zugewandt ist, wobei die Signalleitung (185) sich dazwischen befindet,
wobei die Lichtphasen-Kompensationsschicht (175) die Phasendifferenz zwischen einem ersten Licht (L1), das durch einen Abschnitt hindurchgeht, der die Signalleitung (185) überlappt, und einem zweiten Licht (L2), das durch einen Abschnitt hindurchgeht, der die Signalleitung (185) nicht überlappt, kompensiert,
wobei sowohl das erste Licht (L1) als auch das zweite Licht (L2) ein externes Licht sind, das auf den Funktionsmodulbereich (20) einfällt, und
wobei die Signalleitung (185) die Lichtphasen-Kompensationsschicht (175) überlappt.

2. Anzeigevorrichtung (100, 1000, 1100, 1200) nach Anspruch 1, ferner umfassend:
eine Ätzstoppschicht (135) im Funktionsmodulbereich (20), die der Signalleitung (185) zugewandt ist, wobei die Lichtphasen-Kompensationsschicht (175) sich dazwischen befindet, und
wobei die Ätzstoppschicht (135) im Funktionsmodulbereich (20) ein transparentes Material einschließt.

3. Anzeigevorrichtung (100, 1000, 1100, 1200) nach Anspruch 2, wobei:
jede der Lichtphasen-Kompensationsschicht (175) und der Ätzstoppschicht (135) eine Ätzrate aufweist, und
die Ätzrate der Ätzstoppschicht (135) kleiner ist als die Ätzrate der Lichtphasen-Kompensationsschicht (175).

4. Anzeigevorrichtung (100, 1000, 1100, 1200) nach Anspruch 2 oder Anspruch 3, wobei die Ätzstoppschicht (135) Indium-Gallium-Zink-Oxid oder amorphes Silizium einschließt.

5. Anzeigevorrichtung (100, 1100) nach Anspruch 4, wobei die Ätzstoppschicht (135) sich in einer Gesamtheit des Funktionsmodulbereichs (20) befindet.

6. Anzeigevorrichtung (1000, 1200) nach Anspruch 4, wobei die Ätzstoppschicht (135) im Funktionsmodulbereich (20) ein Ätzstoppmuster definiert, das von der anorganischen Isolierschicht (170) des Anzeigebereichs (10) beabstandet ist.

7. Anzeigevorrichtung (100, 1000, 1100, 1200) nach einem der Ansprüche 1 bis 6, wobei die Signalleitung (185) ein leitfähiges Metalloxid oder ein transparentes leitfähiges Material einschließt, wobei optional das transparente leitfähige Material Indium-ZinnOxid, Indium-Zink-Oxid oder Indium-Gallium-Oxid einschließt.

8. Anzeigevorrichtung (100, 1000, 1100, 1200) nach einem der Ansprüche 1 bis 7, wobei die anorganische Isolierschicht (170) Siliziumoxid oder Siliziumnitrid einschließt.

9. Anzeigevorrichtung (100, 1000, 1100, 1200) nach einem der Ansprüche 1 bis 8, wobei innerhalb des Funktionsmodulbereichs (20),
jede der organischen Isolierschicht (210), der Lichtphasen-Kompensationsschicht (175) und der Signalleitung (185) einen Brechungsindex aufweist, und
der Brechungsindex der organischen Isolierschicht (210) größer als der Brechungsindex der Lichtphasen-Kompensationsschicht (175) und kleiner als der Brechungsindex der Signalleitung (185) ist, wobei optional der Brechungsindex der Signalleitung (185) in einem Bereich des sichtbaren Lichts etwa 1,9 oder mehr beträgt.

10. Anzeigevorrichtung (100, 1000, 1100, 1200) nach einem der Ansprüche 1 bis 9, ferner innerhalb des Funktionsmodulbereichs (200) umfassend:
ein Substrat (110), das der Signalleitung (185) zugewandt ist, wobei die Lichtphasen-Kompensationsschicht (175) sich dazwischen befindet, und
ein Funktionsmodul (FM), das eine Funktion der Anzeigevorrichtung (100, 1000, 1100, 1200) mit Licht bereitstellt, wobei das Funktionsmodul (FM) der Lichtphasen-Kompensationsschicht (175) zugewandt ist, wobei das Substrat (110) sich dazwischen befindet, wobei optional das Funktionsmodul (FM) ein Kameramodul, ein Gesichtserkennungssensor-Modul, ein Pupillenerkennungssensor-Modul, ein Beschleunigungssensor-Modul, ein Annäherungssensor-Modul, ein Infrarotsensor-Modul oder ein Beleuchtungsstärkesensor-Modul einschließt.

11. Anzeigevorrichtung (100, 1000, 1100, 1200) nach einem der Ansprüche 1 bis 10, ferner umfassend:
eine Pixelschaltungsstruktur (501) im Pixelschaltungsbereich (30), die ein Halbleiterelement (200) einschließt; und
eine Emissionsstruktur im Funktionsmodulbereich (20), die mit der Pixelschaltungsstruktur (501) des Pixelschaltungsbereichs (30) verbunden ist, wobei optional die Signalleitung (185) die Pixelschaltungsstruktur (501) des Pixelschaltungsbereichs (30) mit der Emissionsstruktur des Funktionsmodulbereichs (20) elektrisch verbindet.

12. Anzeigevorrichtung (1100, 1200) nach Anspruch 1, umfassend:
ein Funktionsmodul (FM), das eine Funktion der Anzeigevorrichtung (1100, 1200) mit Licht bereitstellt;
wobei die anorganische Isolierschicht (170) eine erste anorganische Isolierschicht (170) ist und die Anzeigevorrichtung (1100, 1200) ferner eine zweite anorganische Isolierschicht (141, 142) sowohl im Anzeigebereich (10) als auch im Funktionsmodulbereich (20) umfasst; und
wobei im Funktionsmodulbereich (20) die organische Isolierschicht (210) der zweiten anorganischen Isolierschicht (141, 142) zugewandt ist, wobei jede der Lichtphasen-Kompensationsschicht (175) und der Signalleitung (185) sich dazwischen befindet.

13. Anzeigevorrichtung (1100, 1200) nach Anspruch 12, ferner umfassend:
eine Ätzstoppschicht (135) im Funktionsmodulbereich (20) zwischen der zweiten anorganischen Isolierschicht (141, 142) und der Lichtphasen-Kompensationsschicht (175), und
wobei die Ätzstoppschicht (135) im Funktionsmodulbereich (20) ein transparentes Material einschließt.

14. Anzeigevorrichtung (1100, 1200) nach Anspruch 13, wobei
(i) jede der Lichtphasen-Kompensationsschicht (175) und der Ätzstoppschicht (135) eine Ätzrate aufweist, und
die Ätzrate der Ätzstoppschicht (135) kleiner ist als die Ätzrate der Lichtphasen-Kompensationsschicht (175); und/oder
(ii) die Ätzstoppschicht (135) Indium-Gallium-Zink-Oxid oder amorphes Silizium einschließt.

15. Anzeigevorrichtung (1100, 1200) nach einem der Ansprüche 12 bis 14, wobei die zweite anorganische Isolierschicht (141, 142) Siliziumoxid oder Siliziumnitrid einschließt.

## Revendications

1. Dispositif d'affichage (100, 1000, 1100, 1200) comprenant :
une zone d'affichage (10), une zone de circuit de pixels (30) adjacente à la zone d'affichage (10), et une zone de module fonctionnel (20) entre la zone d'affichage (10) et la zone de circuit de pixels (30),
une couche isolante inorganique (170) dans la zone d'affichage (10),
une couche de compensation de phase de lumière (175) dans la zone de module fonctionnel (20) et incluant un même matériau que la couche isolante inorganique (170) de la zone d'affichage (10),
une ligne de signal (185) correspondant à la couche de compensation de phase de lumière (175), dans la zone de module fonctionnel (20), et s'étendant de la zone de module fonctionnel (20) jusqu'à la zone de circuit de pixels (30), et
une couche isolante organique (210) faisant face à la couche isolante inorganique (170), dans la zone d'affichage (10), et s'étendant de la zone d'affichage (10) jusqu'à la zone de module fonctionnel (20) pour faire face à la couche de compensation de phase de lumière (175), la ligne de signal (185) étant située entre celles-ci,
dans lequel la couche de compensation de phase de lumière (175) compense la différence de phase entre une première lumière (L1) passant à travers une partie chevauchant la ligne de signal (185), et une deuxième lumière (L2) passant à travers une partie ne chevauchant pas la ligne de signal (185),
dans lequel la première lumière (L1) et la deuxième lumière (L2) sont toutes deux une lumière externe, incidente sur la zone de module fonctionnel (20), et
dans lequel la ligne de signal (185) chevauche la couche de compensation de phase de lumière (175).

2. Dispositif d'affichage (100, 1000, 1100, 1200) selon la revendication 1, comprenant en outre :
une couche d'arrêt de gravure (135) faisant face à la ligne de signal (185), la couche de compensation de phase de lumière (175) étant située entre celles-ci, dans la zone de module fonctionnel (20), et
la couche d'arrêt de gravure (135) dans la zone de module fonctionnel (20) incluant un matériau transparent.

3. Dispositif d'affichage (100, 1000, 1100, 1200) selon la revendication 2, dans lequel :
chacune de la couche de compensation de phase de lumière (175) et de la couche d'arrêt de gravure (135) présente une vitesse de gravure, et
la vitesse de gravure de la couche d'arrêt de gravure (135) est inférieure à la vitesse de gravure de la couche de compensation de phase de lumière (175).

4. Dispositif d'affichage (100, 1000, 1100, 1200) selon la revendication 2 ou la revendication 3, dans lequel la couche d'arrêt de gravure (135) inclut de l'oxyde d'indium, de gallium et de zinc ou du silicium amorphe.

5. Dispositif d'affichage (100, 1100) selon la revendication 4, dans lequel la couche d'arrêt de gravure (135) est dans l'intégralité de la zone de module fonctionnel (20).

6. Dispositif d'affichage (1000, 1200) selon la revendication 4, dans lequel la couche d'arrêt de gravure (135) dans la zone de module fonctionnel (20) définit un motif d'arrêt de gravure espacé de la couche isolante inorganique (170) de la zone d'affichage (10).

7. Dispositif d'affichage (100, 1000, 1100, 1200) selon l'une quelconque des revendications 1 à 6, dans lequel la ligne de signal (185) inclut un oxyde de métal conducteur ou un matériau conducteur transparent, optionnellement dans lequel le matériau conducteur transparent inclut de l'oxyde d'indium et d'étain, de l'oxyde d'indium et de zinc ou de l'oxyde d'indium et de gallium.

8. Dispositif d'affichage (100, 1000, 1100, 1200) selon l'une quelconque des revendications 1 à 7, dans lequel la couche isolante inorganique (170) inclut de l'oxyde de silicium ou du nitrure de silicium.

9. Dispositif d'affichage (100, 1000, 1100, 1200) selon l'une quelconque des revendications 1 à 8, dans lequel, à l'intérieur de la zone de module fonctionnel (20),
chacune d'e la couche isolante organique (210), de la couche de compensation de phase de lumière (175) et de la ligne de signal (185) présente un indice de réfraction, et
l'indice de réfraction de la couche isolante organique (210) est supérieur à l'indice de réfraction de la couche de compensation de phase de lumière (175) et inférieur à l'indice de réfraction de la ligne de signal (185), optionnellement dans lequel l'indice de réfraction de la ligne de signal (185) est d'environ 1,9 ou plus dans un domaine de lumière visible.

10. Dispositif d'affichage (100, 1000, 1100, 1200) selon l'une quelconque des revendications 1 à 9, comprenant en outre à l'intérieur de la zone de module fonctionnel (200) :
un substrat (110) faisant face à la ligne de signal (185), la couche de compensation de phase de lumière (175) étant située entre ceux-ci, et
un module fonctionnel (FM) qui fournit une fonction du dispositif d'affichage (100, 1000, 1100, 1200), avec de la lumière, le module fonctionnel (FM) faisant face à la couche de compensation de phase de lumière (175), le substrat (110) étant situé entre ceux-ci, optionnellement dans lequel le module fonctionnel (FM) inclut un module de caméra, un module de capteur de reconnaissance faciale, un module de capteur de reconnaissance de pupille, un module de capteur d'accélération, un module de capteur de proximité, un module de capteur infrarouge ou un module de capteur d'éclairement lumineux.

11. Dispositif d'affichage (100, 1000, 1100, 1200) selon l'une quelconque des revendications 1 à 10, comprenant en outre :
une structure de circuit de pixels (501) dans la zone de circuit de pixels (30) et incluant un élément semiconducteur (200), et
une structure d'émission dans la zone de module fonctionnel (20) et connectée à la structure de circuit de pixels (501) de la zone de circuit de pixels (30), optionnellement dans lequel la ligne de signal (185) connecte électriquement la structure de circuit de pixels (501) de la zone de circuit de pixels (30) à la structure d'émission de la zone de module fonctionnel (20).

12. Dispositif d'affichage (1100, 1200) selon la revendication 1, comprenant :
un module fonctionnel (FM) qui assure une fonction du dispositif d'affichage (1100, 1200), avec de la lumière,
dans lequel la couche isolante inorganique (170) est une première couche isolante inorganique (170) et le dispositif d'affichage (1100, 1200) comprend en outre une deuxième couche isolante inorganique (141, 142) à la fois dans la zone d'affichage (10) et la zone de module fonctionnel (20), et
dans lequel, dans la zone de module fonctionnel (20), la couche isolante organique (210) fait face à la deuxième couche isolante inorganique (141, 142), chacune de la couche de compensation de phase de lumière (175) et de la ligne de signal (185) étant située entre celles-ci.

13. Dispositif d'affichage (1100, 1200) selon la revendication 12, comprenant en outre :
une couche d'arrêt de gravure (135) entre la deuxième couche isolante inorganique (141, 142) et la couche de compensation de phase de lumière (175), dans la zone de module fonctionnel (20), et
la couche d'arrêt de gravure (135) dans la zone de module fonctionnel (20) incluant un matériau transparent.

14. Dispositif d'affichage (1100, 1200) selon la revendication 13, dans lequel :
i) chacune de la couche de compensation de phase de lumière (175) et de la couche d'arrêt de gravure (135) présente une vitesse de gravure, et
la vitesse de gravure de la couche d'arrêt de gravure (135) est inférieure à la vitesse de gravure de la couche de compensation de phase de lumière (175), et/ou
ii) la couche d'arrêt de gravure (135) inclut de l'oxyde d'indium, de gallium et de zinc ou du silicium amorphe.

15. Dispositif d'affichage (1100, 1200) selon l'une quelconque des revendications 12 à 14, dans lequel la deuxième couche isolante inorganique (141, 142) inclut de l'oxyde de silicium ou du nitrure de silicium.
